# EUROPEAN PATENT SPECIFICATION

(11) **EP 1 531 051 B1**
(45) Date of publication and mention of the grant of the patent: **31.12.2008**
(21) Application number: 04257092.9
(22) Date of filing: 16.11.2004
(51) Int. Cl.: B41J 2/165, H05K 1/02

(54) **Improvements relating to inkjet printerhead blockage detection**
Verbesserte Detektierung von Tintenstrahldruckkopfverstopfungen
Amélorations apportées à la détection des obstructions de têtes d'imprimante à jet d'encre

(30) Priority: 17.11.2003 GB 0326733
(43) Date of publication of application: 18.05.2005
(73) Proprietor: FUJIFILM Corporation, Minato-ku Tokyo (JP)
(72) Inventor: Gardner, Ian, Cambridge, CB4 5TT (GB); Bromley, Nigel, Milton Keynes, MK8 9EL (GB); Gouch, Martin, Herts, HP2 4ND (GB)
(74) Representative: Skone James, Robert Edmund

(56) References cited:
- EP-A- 0 988 990
- US-A1- 2002 033 851
- US-A1- 2002 067 925
- US-B1- 6 637 853
- PATENT ABSTRACTS OF JAPAN vol. 2000, no. 13, 5 February 2001 (2001-02-05) & JP 2000 272116 A (SHARP CORP), 3 October 2000 (2000-10-03)

## Description

The invention relates to printing images on substrates using an ink jet printer.

In the use of Inkjet printers to print images onto paper or other substrates there is sometimes a problem with the ink nozzles blocking up with dust or debris. When this happens a single line is either not printed on the paper or the position of the line printed is displaced and often blurred. This leads to a defect in the printing. For normal inkjet printing of ink on paper a single line defect is not normally seen by the eye. The blockages can be cleared by ejecting large amounts of ink through the nozzle and washing the blockage away. This is normally called flushing and the ink is dumped into a waste tank. It is typical for inkjet printers to do this flushing periodically as either a rectifying or preventative measure.

An example of a conventional procedure for detecting clogging of print nozzles is described in US-A-2002/0033851. In this case, a test pattern is printed and then scanned to detect deviations from an expected pattern. This provides a basic solution to the detection of clogged print nozzles but is not suitable when the object being printed is not tolerant to a missing line. For instance, when printing of a UV resist to define a UV mask for a printing plate, then periodically rectifying a blocked nozzle is not acceptable as a whole plate is written off when a single defect occurs. One solution to the problem is to flush the nozzles at the end of each pass of the plate. It is not normally the case that a rapid blocking of the nozzles occurs where one second a nozzle is clear and the next it is completely blocked or greatly obscured so such a strategy could be adopted. Unfortunately this is wasteful in both time and ink. The time is wasted in the time taken to flush the nozzles and clearly the ink flushed is wasted.

In accordance with the present invention, a method of printing an image on a substrate, the method comprises controlling an inkjet printer head having a plurality of nozzles to print the image on the substrate in a series of swaths, each swath extending in a printer head scan direction; periodically checking for full or partial blockages in a nozzle of the inkjet printer head by causing each nozzle to print a same predetermined pattern on a substrate following each swath in the printer head scan direction and analysing the patterns to determine any differences between them and to identify a blocked or partially blocked nozzle if its printed pattern differs by more than a predetermined amount from that of the other nozzle(s), wherein the checking step is carried out following each swath of the inkjet printer head across the substrate in the printer head scan direction.

The invention can detect when nozzles are completely blocked and also when they are partially blocked or beginning to block. In the case of a partial blockage the direction of the ink droplet is altered giving the droplet a sideways motion (along or transverse to the scan direction) and sometimes the size of drop deposited changes. The predetermined pattern or "feducial marks" are arranged and measured so that small changes in direction of fire of each nozzle can be detected and the size of drop from each nozzle can be detected. Once this discrepancy in nozzle performance has been detected the nozzle can then be flushed at the earliest opportunity, e.g. prior to the next swath, before the change in performance becomes large enough to significantly affect the finished pattern on the substrate being printed on.

The predetermined pattern or "feducial marks" can include a sequence of dots and in order to simplify subsequent processing, these dots are preferably equally spaced apart. In that event, the analysis step can comprise analysing the spaces between the dots in the different patterns.

Preferably, the predetermined pattern includes a continuous line portion.

Although the analysis method can be carried out manually, preferably the method further comprises, prior to the analysing step, scanning the patterns with a detector to generate an electronic representation of the patterns. In this way, the analysis can be carried out electronically and automatically.

The electronic analysis can be achieved using a variety of techniques including a Fourier Transform or wavelet analysis.

Conveniently, at least some of the nozzles print the predetermined patterns alongside one another for ease of comparison although one or more of the nozzles could print its pattern spaced longitudinally from another pattern. In either event, this enables differences between the patterns printed by different nozzles to be easily compared, thus revealing any discrepancies in one of the patterns due to a faulty nozzle.

The analysis step may comprise detecting the absence of part of the predetermined pattern. For example, the absence of a dot in the pattern could be detected.

In some cases, the nozzles are controlled to print their respective patterns at predetermined positions relative to a datum, the analysis step comprising detecting an offset between a printed pattern and its expected position with respect to its datum.

In some cases, the predetermined pattern and printed image may be printed using a marker ink in order to increase contrast between the predetermined pattern and the underlying substrate and increase signal to noise ratio.

An example of a method according to the invention will now be described with reference to the accompanying drawings, in which:-
Figures 1, 2 and 3 illustrate three different examples of printed predetermined patterns or feducial marks;
Figure 4 is a plan of a substrate showing the feducial marks on an enlarged scale; and,
Figure 5 is a schematic diagram of apparatus for carrying out the method.

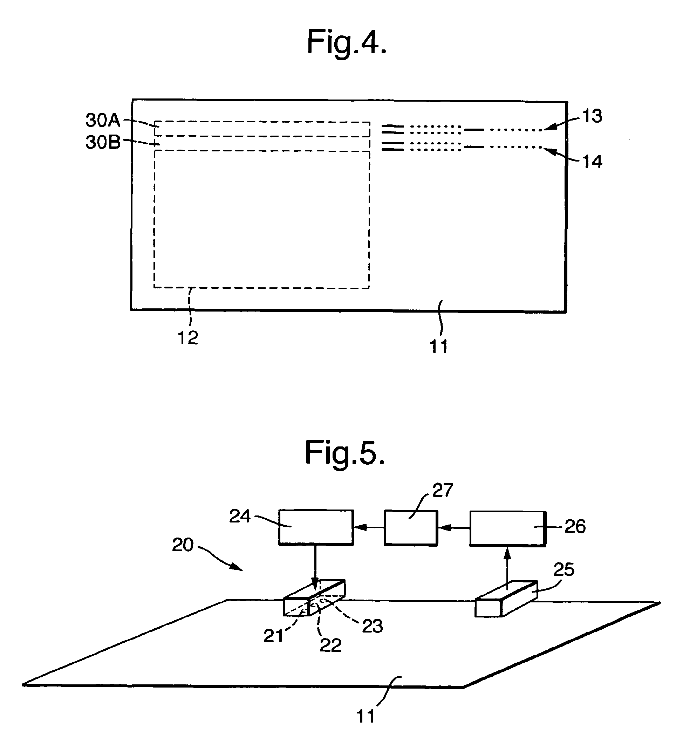

In this example, an inkjet printer, shown schematically at 20 in Figure 5, has three nozzles 21-23 in its head 10 connected to a controller 24. In practice, many more than three nozzles would be provided. The nozzles 21-23 are controlled to print an image 12 (Figure 4) onto a substrate 11 such as a printing plate or PCB along substantially parallel tracks as the head scans across the substrate.

In some cases, the printing head 10 is scanned (moved) across the substrate 11 while in other examples the head 10 is stationary and the substrate 11 is moved.

As mentioned above, the substrate 11 can include a variety of materials but the invention is particularly suitable for use with printing a UV mask onto a printing plate.

The printer 20 prints an image 12 in a series of adjacent swaths or scans across the substrate 11. (Only two swaths 30A,30B are shown in Figure 4.) At the end of each swath, defined by a single scan of the head 10 across the substrate 11, the inkjet printer is instructed to cause each nozzle 21-23 to print a predetermined pattern or feducial marks which, in this example, comprises a solid line followed by eight equally spaced dots. Figure 4 illustrates schematically one set of such patterns 13 corresponding to swath 30A and another set at 14 corresponding to swath 30B. These patterns are shown at an enlarged scale relative to the image 12. Although the patterns 13,14 are printed on the substrate 11 in this example, they could be printed on a separate substrate and possibly in a different colour from the image 12.

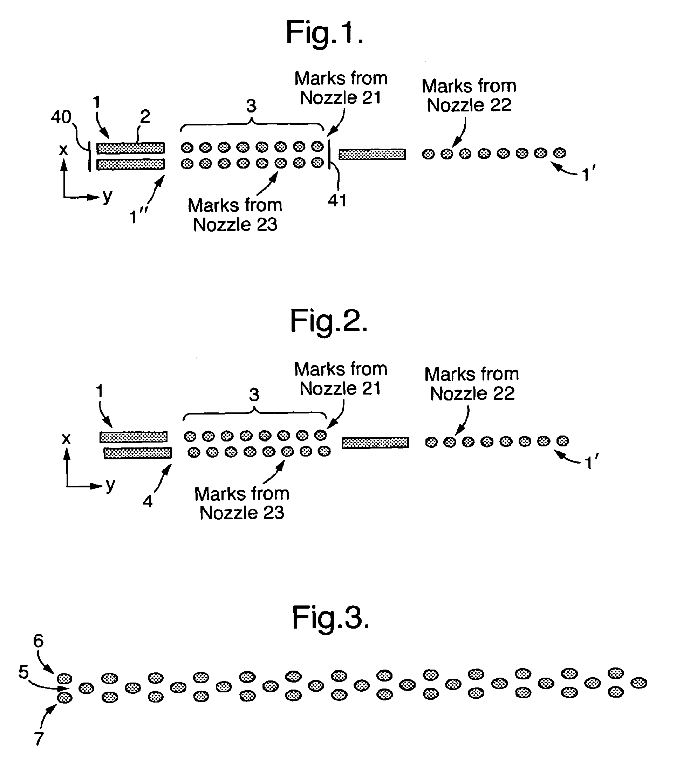

An example of the pattern 13 is shown in more detail in Figure 1 where the dimension "y" corresponds to the scanning direction and the direction "x" corresponds to a direction perpendicular to the scanning direction. In this example, the first nozzle 21 prints feducial marks 1 comprising a solid line 2 and a set of eight dots 3 relative to an unprinted datum 40. The second and third nozzles 22,23 are controlled to print the same pattern indicated at 1',1" respectively relative to an unprinted datum 41 and the datum 40 respectively.

A variety of different types of analysis can be carried out. In a typical example, a Fourier Transform technique is used where the phase of the fundamental of the series of single dots is determined. Other techniques could be used such as measuring the centre of gravity of each single dot, subtracting the position of each of the dots from the corresponding dot of the same number in the series of another nozzle. Then averaging these differences so that each dot has an average distance between itself and either every other dot or a chosen dot. A dot would then show an error in the x and/or y direction if this distance was different from other corresponding dot to dot differences, thus indicating a possible (partial) blockage of the corresponding nozzle. The line part 2 of the feducial marks can be used also to determine any variation in the x direction.

Further processing techniques which can be used include wavelet analysis and Short Term Fourier Transforms.

Figure 2 illustrates an example in which the nozzle 23 is partially blocked so that it has printed the feducial marks out of alignment, as seen at 4, with the feducial marks 1,1' printed by nozzles 21 and 22 respectively.

In the Figure 2 example, a Fourier analysis would operate as follows. Each line of dots is segmented into separate segments so each segment contains a single nozzle output. These segments are then individually Fourier transformed with a 2D discreet Fourier transform, or 2D discreet fast Fourier transform.

The peak associated with the recurring dot pattern is reviewed and its phase in the y direction determined (x direction is measured using the line). The phase for odd numbered segments should be the same and the phase for even numbered segments should be the same and at a known relationship to the odd numbered segments. Any segment with an unexpected phase would be then considered to ejecting ink at an angle and in need of flushing.

An alternative would be to segment the images as before and to sum up the columns of pixels and perform a 1D Fourier analysis looking at the phase of the peak in the same way as before.

Wavelet analysis is the same as Fourier analysis but using wavelets instead of sine waves as the basis. In this case, a wavelet is picked that looks like an ink dot. In this way, the analysis can be made to be more sensitive than the standard Fourier transform technique because it is tuned to detecting dots not sine waves.

Short term Fourier techniques are similar to the normal Fourier analysis but instead of sampling all the data at once from one segment, the segment is further divided into shorter segments and each segment analysed. This is a technique used in speech analysis and is sensitive to short term changes in frequency and phase. Thus, the noise in dot position along a single line could be analysed. This would show nozzles with intermittent errors.

It should also be noted that it is not essential to include a line segment in the feducial mark pattern. As can be seen in Figure 3, each pattern in this example comprises a set of dots only with the dots 5 from nozzle 22 being out of alignment with the dots 26,27 from nozzles 21 and 23 respectively. It should also be noted in this case that all the nozzles have been controlled to print their feducial marks simultaneously.

The feducial marks will usually be printed in the same colour as used for printing the image on the substrate 11, such as a UV mask. In some cases, the colour of the substrate 11 is such that it is difficult to discern the feducial marks. In these cases, the printing ink may include a marker such as a dye which increases contrast with the substrate colour.

Although the feducial marks could be analysed manually, preferably, the printed, feducial marks are scanned by a scanning device such as a line scan CCD detector 25, or a CMOS detector. This enables the marks to be analysed by computer. Thus, signals from the CCD 25 representing the appearance of the patterns 13,14 are converted to digital form in an A/D converter 26 and then forwarded to a microprocessor 27. The microprocessor 27 analyses the marks within each pattern 13,14 as described above and then if appropriate, causes the controller 24 to unblock one or more of the nozzles 21-23 before commencement of the next printing swath 30.

## Claims

1. A method of printing an image on a substrate (11), the method comprising controlling an inkjet printer head having a plurality of nozzles to print the image (12) on the substrate (11) in a series of swaths (30a,30b), each swath extending in a printer head scan direction (y); periodically checking for full or partial blockages in a nozzle of the inkjet printer head by causing each nozzle to print a same predetermined pattern (13,14) on a substrate (e.g. 11) following each swath in the printer head scan direction and analysing the patterns (13,14) to determine any differences between them and to identify a blocked or partially blocked nozzle if its printed pattern differs by more than a predetermined amount from that of the other nozzle(s), wherein the checking step is carried out following each swath of the inkjet printer head across the substrate in the printer head scan direction.

2. A method according to claim 1, further comprising scanning each pattern with a detector (25) to generate an electronic representation of the patterns; and performing the analysis step by computer (27).

3. A method according to claim 2, wherein the scanning step is carried out using one of a line scan CCD detector (25), a 2D CCD detector, and a CMOS detector.

4. A method according to any of the preceding claims, wherein the predetermined pattern includes a sequence of dots (21,23).

5. A method according to claim 4, wherein the dots (21,23) are intended to be equally spaced apart when a nozzle is not partially or completely blocked.

6. A method according to claim 4 or claim 5, wherein the analysis step comprises determining the spacing between dots printed by different nozzles and comparing the spacings.

7. A method according to any of the preceding claims, wherein the analysis step comprises detecting the absence of part of the predetermined pattern.

8. A method according to any of the preceding claims, wherein the nozzles are controlled to print their respective patterns at predetermined positions relative to a datum, the analysis step comprising detecting an offset between a printed pattern and its expected position with respect to its datum.

9. A method according to any of the preceding claims, where at least some of the nozzles are controlled to print the predetermined patterns alongside one another.

10. A method according to any of the preceding claims, wherein the predetermined pattern includes a continuous line segment.

11. A method according to any of the preceding claims, wherein the predetermined patterns are printed in a colour which contrasts with that of the substrate.

12. A method according to any of the preceding claims, further comprising flushing at least any nozzle which has been found to be blocked or partially blocked.

13. A method according to claim 12, wherein the said nozzle is flushed prior to printing the next swath.

14. A method according to any of the preceding claims, wherein the substrate comprises a printing plate or PCB, the inkjet printer head printing a photoresist image on the substrate.

15. A method according to any of the preceding claims, wherein the predetermined patterns are printed on the same substrate as the image.

## Patentansprüche

1. Verfahren zum Drucken eines Bildes auf ein Substrat (11), wobei das Verfahren umfasst: Steuern eines Tintenstrahldruckerkopfes, der eine Mehrzahl von Düsen zum Drucken des Bildes (12) auf das Substrat (11) in einer Serie von Bahnen (30a, 30b) aufweist, wobei sich jede Bahn in einer Druckerkopf-Abtastrichtung (y) erstreckt; periodisches Überprüfen auf vollständige oder teilweise Blockierungen in einer Düse des Tintenstrahldruckerkopfes, durch Veranlassen jeder Düse, ein gleiches vorgegebenes Muster (13, 14) auf ein Substrat (z.B. 11) zu drucken, das jeder Bahn in der Druckerkopf-Abtastrichtung nachfolgt, und Analysieren der Muster (13, 14), um jegliche Unterschiede zwischen ihnen festzustellen und um eine blockierte oder teilweise blockierte Düse zu identifizieren, falls ihr gedrucktes Muster um mehr als einen vorgegebenen Betrag von dem der anderen Düse(n) abweicht, wobei der Überprüfungsschritt folgend auf jede Bahn des Tintenstrahldruckerkopfes über das Substrat in der Druckerkopf-Abtastrichtung ausgeführt wird.

2. Verfahren nach Anspruch 1, weiter umfassend ein Abtasten jedes Musters mit einem Detektor (25), um eine elektronische Repräsentation der Muster zu generieren; und Durchführen des Analyseschritts mittels eines Computers (27).

3. Verfahren nach Anspruch 2, wobei der Abtastschritt durch die Verwendung eines aus einem Zeilenabtast-CCD-Detektor (25), einem 2D-CCD-Detektor und einem CMOS-Detektor ausgeführt wird.

4. Verfahren nach einem der vorhergehenden Ansprüche, wobei das vorgegebene Muster eine Sequenz von Punkten (21, 23) enthält.

5. Verfahren nach Anspruch 4, wobei die Punkte (21, 23) gleich voneinander beabstandet sein sollen, wenn eine Düse nicht teilweise oder vollständig blockiert ist.

6. Verfahren nach Anspruch 4 oder Anspruch 5, wobei der Analyseschritt ein Ermitteln des Abstandes zwischen Punkten, die von verschiedenen Düsen gedruckt sind, und ein Vergleichen der Abstände umfasst.

7. Verfahren nach einem der vorhergehenden Ansprüche, wobei der Analyseschritt ein Detektieren des Fehlens eines Teils des vorgegebenen Musters umfasst.

8. Verfahren nach einem der vorhergehenden Ansprüche, wobei die Düsen gesteuert werden, ihre jeweiligen Muster an vorgegebenen Positionen relativ zu einem Bezugspunkt zu drucken, wobei der Analyseschritt ein Detektieren eines Versatzes zwischen einem gedruckten Muster und seiner erwarteten Position bezüglich seines Bezugspunkts umfasst.

9. Verfahren nach einem der vorhergehenden Ansprüche, wobei zumindest einige der Düsen gesteuert werden, die vorgegebenen Muster entlang einander zu drucken.

10. Verfahren nach einem der vorhergehenden Ansprüche, wobei das vorgegebene Muster ein durchgehendes Liniensegment enthält.

11. Verfahren nach einem der vorhergehenden Ansprüche, wobei die vorgegebenen Muster in einer Farbe gedruckt werden, die sich von der des Substrats abhebt.

12. Verfahren nach einem der vorhergehenden Ansprüche, weiter umfassend ein Spülen zumindest einer Düse, die als blockiert oder teilweise blockiert erkannt wurde.

13. Verfahren nach Anspruch 12, wobei die Düse vor dem Drucken der nächsten Bahn gespült wird.

14. Verfahren nach einem der vorhergehenden Ansprüche, wobei das Substrat eine Druckplatte oder ein PCB (printed circuit board, gedruckte Schaltung) umfasst, wobei der Tintenstrahldruckerkopf ein Photoresist-Bild auf das Substrat druckt.

15. Verfahren nach einem der vorhergehenden Ansprüche, wobei die vorgegebenen Muster auf dasselbe Substrat wie das Bild gedruckt werden.

## Revendications

1. Procédé d'impression d'une image sur un support (11), le procédé comprenant la commande d'une tête d'impression à jet d'encre présentant plusieurs buses pour imprimer l'image (12) sur le support (11) dans une série de passes (30a, 30b), chaque passe s'étendant dans une direction de balayage (y) de la tête d'impression; le contrôle périodique de blocages complets ou partiels dans une buse de la tête d'impression à jet d'encre, en amenant chaque buse à imprimer un même motif (13, 14) prédéterminé sur un support (par exemple 11) après chaque passe dans la direction de balayage de la tête d'impression, et l'analyse des motifs (13, 14) pour déterminer toute différence entre eux et identifier une buse bloquée ou partiellement bloquée si son motif imprimé diffère de plus qu'une grandeur prédéterminée de celui de la ou des autres buses, l'étape de contrôle étant mise en oeuvre à la suite de chaque passe de la tête d'impression à jet d'encre en travers du support dans la direction de balayage de la tête d'impression.

2. Procédé selon la revendication 1, comprenant en outre les étapes consistant à balayer chaque motif par un capteur (25) pour générer une représentation électronique des motifs, et à effectuer l'étape d'analyse par un ordinateur (27).

3. Procédé selon la revendication 2, dans lequel l'étape de balayage est mise en oeuvre en utilisant l'un parmi un capteur CCD à balayage linéaire (25), un capteur CCD à 2D et un capteur CMOS.

4. Procédé selon l'une quelconque des revendications précédentes, dans lequel le motif prédéterminé comprend une suite de points (21, 23).

5. Procédé selon la revendication 4, dans lequel les points (21, 23) sont prévus pour être équidistants lorsqu'une buse n'est ni partiellement, ni complètement bloquée.

6. Procédé selon la revendication 4 ou la revendication 5, dans lequel l'étape d'analyse comprend la détermination de l'écartement entre points imprimés par différentes buses, et la comparaison des écartements.

7. Procédé selon l'une quelconque des revendications précédentes, dans lequel l'étape d'analyse comprend la détection de l'absence d'une partie du motif prédéterminé.

8. Procédé selon l'une quelconque des revendications précédentes, dans lequel les buses sont commandées pour imprimer leurs motifs correspondants en des positions prédéterminées par rapport à une référence, l'étape d'analyse comprenant la détection d'un décalage entre un motif imprimé et sa position attendue par rapport à sa référence.

9. Procédé selon l'une quelconque des revendications précédentes, dans lequel au moins certaines des buses sont commandées pour imprimer les motifs prédéterminés les uns le long des autres.

10. Procédé selon l'une quelconque des revendications précédentes, dans lequel le motif prédéterminé comprend un segment de ligne continu.

11. Procédé selon l'une quelconque des revendications précédentes, dans lequel les motifs prédéterminés sont imprimés dans une couleur qui contraste avec celle du support.

12. Procédé selon l'une quelconque des revendications précédentes, comprenant de plus une chasse d'au moins toute buse qui a été trouvée bloquée ou partiellement bloquée.

13. Procédé selon la revendication 12, dans lequel ladite buse subit une chasse avant impression de la passe suivante.

14. Procédé selon l'une quelconque des revendications précédentes, dans lequel le support comprend une plaque d'impression ou une plaque de circuit imprimé (PCB), la tête d'impression à jet d'encre imprimant une image de photorésist sur le support.

15. Procédé selon l'une quelconque des revendications précédentes, dans lequel les motifs prédéterminés sont imprimés sur le même support que l'image.
